(19) Europäisches Patentamt
European Patent Office
Office européen des brevets

(11) **EP 0 579 018 B1**

(12) **EUROPÄISCHE PATENTSCHRIFT**

(45) Veröffentlichungstag und Bekanntmachung des Hinweises auf die Patenterteilung:
**30.09.1998 Patentblatt 1998/40**

(51) Int Cl.⁶: **C23C 14/54**, H01J 37/305

(21) Anmeldenummer: **93110252.9**

(22) Anmeldetag: **28.06.1993**

(54) **Verfahren zur Herstellung einer Metalloxidschicht, Vakuumbehandlungsanlage hierfür sowie mit mindestens einer Metalloxidschicht beschichteter Teil**

Process for production of a metal oxide layer, vacuum treatment apparatus for the process and article coated with at least one metal oxide layer

Procédé de production d'une couche d'oxyde métallique, appareillage de traitement sous vide pour la mise en oeuvre du procédé et article revêtu d'au moins une couche d'oxyde métallique

(84) Benannte Vertragsstaaten:
**AT CH DE FR GB LI NL**

(30) Priorität: **02.07.1992 CH 2095/92**

(43) Veröffentlichungstag der Anmeldung:
**19.01.1994 Patentblatt 1994/03**

(73) Patentinhaber: **BALZERS AKTIENGESELLSCHAFT**
**9496 Balzers (LI)**

(72) Erfinder: **Peter, Günter, Dr.**
**CH-8889 Plons (CH)**

(74) Vertreter: **Troesch Scheidegger Werner AG Patentanwälte,**
**Siewerdtstrasse 95,**
**Postfach**
**8050 Zürich (CH)**

(56) Entgegenhaltungen:
**EP-A- 0 005 641          EP-A- 0 302 506**
**WO-A-90/02215          WO-A-90/02215**
**FR-A- 2 341 668          FR-A- 2 341 668**
**GB-A- 2 158 104**

• **REVIEW OF SCIENTIFIC INSTRUMENTS Bd. 57, Nr. 5, Mai 1986, NEW YORK US Seiten 937 - 940 SEVENHANS ET AL. 'Mass Spectrometer Controlled Electron Beam Evaporation Synthesis of Multilayered Materials'**

## Beschreibung

Die vorliegende Erfindung betrifft ein Verfahren nach dem Oberbegriff von Anspruch 1, eine Vakuumbehandlungsanlage zur Ausführung des genannten Verfahrens nach demjenigen von Anspruch 29 sowie ein mit mindestens einer Metalloxidschicht beschichteter Teil nach dem Anspruch 43. Dabei sollen unter dem Begriff "Metalloxid" auch die Oxide der Halbleiter verstanden sein.

Solche Metalloxidschichten werden bekanntlich in vielen Anwendungen eingesetzt. Ohne Anspruch auf Vollständigkeit werden sie eingesetzt

- als Dielektrika zur elektronischen Isolation zwischen leitenden Schichten,

- als Dielektrika in Dünnschichtkondensatoren,

- als Schutzschicht zur Kapselung z.B. von integrierten Schaltkreisen,

- als Isolatoren zwischen Supraleitern zur Herstellung schneller Schalter nach dem Josephson-Effekt (Rosenberg, "The Solid State", Oxford University Press, 1988),

- im Schichtaufbau bei Solarzellen,

- im Schichtaufbau bei optischen Bauelementen,

- wegen ihrer Eigenschaft als Festkörper-Elektrolyt, als Gassensoren,

- an elektrochemischen Halbzellen zur EMK-Messung, insbesondere auch für die pH-Messung, dabei auch für ionensensitive Halbleiter-Bauteile, wie als GATE-Schicht für Feldeffekt-Transistoren, sog. ISFET.

Bei all diesen Anwendungen ist eine wesentliche Anforderung an die Schicht diejenige, dass keine Mikrorisse in der Schicht vorliegen. Derartige Mikrorisse können in allen Fällen die Funktion der Oxidschicht aufheben. So wird beispielsweise beim Einsatz als pH-Sensorschicht durch derartige Mikrorisse die Schicht kurzgeschlossen.

Eine weitere wesentliche Anforderung bei allen erwähnten Anwendungen ist diejenige einer guten Haftung auf der Unterlage, insbesondere auch unter dem Aspekt thermischer Spannungen sowie der Störstellen- bzw. Fremdeinschlussfreiheit.

Aus der EP-A-0 302 506 ist es bekannt, bei der Herstellung elektrisch supraleitender Schichten die Verdampfungs-Freisetzungsrate zu regeln und die Energie auf dem zu beschichtenden Substrat auftreffender Sauerstoffionen möglichst tief zu halten. Die Substrattemperatur wird auf 800°C gehalten.

Aus der WO-A-90/02215 ist es weiter bekannt, wiederum bei der Herstellung supraleitender Schichten die Materialstruktur des aufwachsenden Filmes, über dessen Dicke, zu variieren.

Aus der FR-A-2 341 668 ist es weiter bekannt, eine defektfreie Zeriumoxidschicht als Blockierschicht einer fotoelektrischen Zelle abzulegen. Es sollen keine grösseren Partikel in der Schicht abgelegt werden.

Aus der GB-A-2 158 104 ist es weiter bekannt, das Verschleissverhalten dünner Oxidschichten an mechanisch hoch beanspruchten Teilen, wie an Düsennadeln, dadurch zu erhöhen, dass man, entlang der Schichtdicke, den Oxidationsgrad des Schichtmaterials stetig erhöht.

Ziel der vorliegenden Erfindung ist es, ein Verfahren eingangs genannter Art vorzuschlagen, mittels welchem die erwähnten Metalloxidschichten industriell gefertigt werden können und dabei den erwähnten Anforderungen betreffs Mikrorisse, Störstellenfreiheit und Haftfestigkeit genügen, sowie eine Vakuumbehandlungsanlage, mittels welcher die genannten Schichten hergestellt werden können, sowie, weiter, Teile, welche industriell gefertigt den erwähnten Anforderungen genügen.

Die erwähnte Aufgabe wird durch ein Verfahren gelöst, welches sich nach dem kennzeichnenden Teil von Anspruch 1 auszeichnet.

Dabei wird definiert:

- der Hochvakuumbereich zwischen $10^{-3}$ und $10^{-6}$ mbar,

- der Ultrahoch-Vakuumbereich: Drücke unter $10^{-6}$ mbar.

Ist im weiteren $Me_hO_k$ die Stöchiometrieform einer gewünschten Oxidationsstufe (z.B. $Si_1O_2$, $Si_1O_1$), wobei h und k positive ganze Zahlen sind, und ist das molare mittlere IST-Verhältnis im Festkörper normiert auf h zwischen Metall und O durch $h/k'$ gegeben, so ist der Oxidationsgrad $\gamma$ gegeben durch $k'/k$, und es gilt

- bei $k'/k = 1$: die Oxidation ist gesättigt;

- bei $k'/k > 1$: die Oxidation ist übersättigt, und

- bei $k'/k < 1$: die Oxidation ist unvollständig.

Bezüglich der Herstellung von Oxidschichten in UHV-Vakuumatmosphäre sei hingewiesen auf den Artikel "Coevaporation of Y-Ba-Cu-O films in an ultra high vacuum plant", J. Edlinger, H. Fischer, J.A. Koprio, G. Peter, J. Ramm, Balzers AG, FL-9496 Balzers, aus Proceedings of the International Conference on High Temperature Superconductivity and Materials and Mechanisms of Supraconductivity, Febr. 29, to March 4, 1988, Interlaken, Switzerland.

Durch die Anfangsevakuation mindestens auf HV-Druckbereich wird die Fehlereinschlussquote in die Schicht minimalisiert. Weiter wird durch die Kombination der Merkmale, dass das Metall so freigesetzt wird, dass die kinetische Energie freigesetzter Metallpartikel an der Unterlage höchstens 10eV beträgt und dass der Oxidationsgrad der Schicht, ausgehend von der Unterlage mit einem zeitlichen Steuerstellraster entsprechend höchstens der Ablagezeit jeweils einer monoatomaren bzw. monomolekularen Schicht, erhöht wird, und dass weiter die Unterlagstemperatur unter 900°C gehalten wird, ein präzis beherrschbarer Auftragungsprozess realisiert. Dadurch, dass die Energie der auf die Unterlage auftreffenden Metallpartikel nach oben limitiert wird, wird entgegen herkömmlicher Bestrebungen zur kommerziellen, industriellen Fertigung von Schichten mit geringen Freisetzungsraten der Metallpartikel an einer Metallpartikelquelle gearbeitet.

Es wird erreicht, dass exakt gesteuert das erwünschte Oxidationsgradprofil zwischen Unterlage und der Schicht, schliesslich mit der erwünschten Stöchiometrie, erreicht wird, wodurch beispielsweise die Aufnahme thermisch bedingter Spannungen zwischen Unterlage und Schicht ohne Rissbildung optimiert werden kann.

Bevorzugterweise wird weiter das Metall gemäss Wortlaut von Anspruch 2 in die Vakuumkammer freigesetzt.

Im weiteren wird vorzugsweise nach dem Wortlaut von Anspruch 3 vorgegangen, was erlaubt, die Freisetzungsrate exakt zu führen, und ermöglicht, das erwähnte Oxidationsgradprofil, nach Massgabe der gleichzeitig zugeführten Sauerstoffmenge pro Zeiteinheit, entsprechend einem vorgegebenen SOLL-Profil exakt zu realisieren.

Dem Wortlaut von Anspruch 4 folgend, können damit auch relativ dicke, höchst homogene Schichten erzeugt werden, mit gleichbleibend beherrschter Stöchiometrie, indem die Drift der zeitlich und über die Freisetzungsfläche gemittelten Rate freigesetzten Metalles kleiner als 5% in 20 Minuten, vorzugsweise als 0,5% in einer Stunde, gehalten wird.

Als Freisetzungsfläche soll verstanden sein die gesamte Fläche einer Metallpartikelquelle, von der innerhalb der Beschichtungszeit Metallpartikel abgegeben werden.

Durch das gleichzeitige Beaufschlagen der Unterlage nach dem Wortlaut von Anspruch 5 mit Sauerstoff und Metallpartikeln wird eine Oxidschicht in situ gewachsen. Passivierungseffekte, wie z.B. bei anodischer Oxidation an Atmosphäre oder elektrochemische Oxidation, können dann nicht auftreten. Da der Ablageprozess mit sehr kleiner kinetischer Energie erfolgt, wesentlich geringer als die Bindungsenergie des Oxides, werden die Eigenschaften bereits abgelegten Oxides durch nachfolgend abgelegte Partikel nicht verändert.

Der gesamte erfindungsgemäss vorgeschlagene Prozess lässt sich im weiteren durch die Beherrschung einiger weniger Prozessparameter, nämlich, wie erwähnt, der Freisetzungsrate des Metalles, zudem der Menge pro Zeiteinheit eingelassenen Sauerstoffes und weiter der Temperatur der Unterlage, worauf sich die Schicht bildet, beherrschen.

Bevorzugterweise wird das Metall nach dem Wortlaut von Anspruch 6 durch Verdampfung freigesetzt, dabei vorzugsweise durch Elektronenstrahlverdampfung, ein Prozess, der insbesondere in der noch zu beschreibenden Art und Weise exakt beherrschbar ist.

Zur exakten Ueberwachung der pro Zeiteinheit freigesetzten Metallmenge wird diese vorzugsweise nach dem Wortlaut von Anspruch 7 während des Beschichtungsprozesses gemessen.

Um dabei aus der vorgenommenen Messung relevante Angaben darüber zu erhalten, welches die im zeitlichen Mittel auf die Unterlage abgelegte Metallrate ist, wird, dem Wortlaut von Anspruch 12 folgend, die Messung im Raumwinkelbereich vorgenommen, unter welchem die Unterlage mit ihrem zu beschichtenden Bereich die Quelle des freigesetzten Metalles sieht. Damit besteht im wesentlichen Proportionalität zwischen der am Messort festgestellten Metallmenge pro Zeiteinheit und der sich auf der Unterlage ablegenden Metallmenge pro Zeit- und Flächeneinheit.

Die Messung wird weiter bevorzugterweise nach dem Wortlaut von Anspruch 8 vorgenommen und weiter dem Wortlaut von Anspruch 9 folgend. Damit wird, bei konstant gehaltener, pro Zeiteinheit zugeführter Sauerstoffmenge, der Oxidationsgrad an der sich aufbauenden Schicht geregelt bzw. regelnd geführt oder bei Mitstellung der pro Zeiteinheit zugeführten Sauerstoffmenge mit gestellt.

Zur Minimalisierung der Fehlereinschlüsse wird weiter, dem Wortlaut von Anspruch 13 folgend, die Vakuumkammer auf UHV-Druckbereich evakuiert, bevor der Beschichtungsprozess begonnen wird, womit Restgaseinflüsse vermieden werden.

Um im weiteren ein in situ-Wachsen der Metalloxidschicht frei von Restgaseinschlüssen weiter zu verbessern, wird vorgeschlagen, nach dem Wortlaut von Anspruch 22 vorzugehen.

Insbesondere für eine exakte Regelung der von der Metallquelle pro Zeiteinheit freigesetzten Metallmenge wird ein Ratesensor nach dem Wortlaut von Anspruch 10, bevorzugterweise auch von Anspruch 11, eingesetzt.

Dabei entspricht die bevorzugterweise gewählte Ansprechzeit ≤ msec insbesondere der Flugzeit von elektronenstrahlverdampften Teilchen bei der erwähnten maximalen kinetischen Energie von ca. 10eV über eine Strecke von 50cm, mithin zwischen der Quelle und einer diesbezüglich auf 50cm Abstand montierten, zu beschichtenden Unterlage.

Im weiteren wird bevorzugterweise der zur Messung der Rate freigesetzten Metalles verwendete Ratesensor nach dem Wortlaut von Anspruch 15 angeordnet, dies vorzugsweise durch Vorsehen einer Druckstufe, realisiert zwischen Metallquelle und Ratesensor einerseits und Sauerstoffeinlass und Unterlage anderseits.

Grundsätzlich wird in einer bevorzugten Ausführungsvariante des erfindungsgemässen Verfahrens nach dem Wortlaut von Anspruch 16 vorgegangen.

Dabei werden bevorzugterweise zwei der drei Grössen, Unterlagentemperatur pro Zeiteinheit und pro Zeiteinheit eingelassene Sauerstoffmenge oder Freisetzungsrate, jeweils konstant gehalten. Vorzugsweise wird bei der Herstellung eines erwünschten Oxidationsgradprofiles bis und mit der Weiterbeschichtung mit der Schicht erwünschter Stöchiometrie die Unterlagentemperatur und entweder die pro Zeiteinheit zugeführte Sauerstoffmenge oder die freigesetzte Metallmenge pro Zeiteinheit konstant gehalten und, entsprechend, die pro Zeiteinheit freigesetzte Metallmenge oder die zugeführte Sauerstoffmenge in regelndem Sinne geführt, gemäss Wortlaut von Anspruch 17.

In manchen Anwendungsfällen der genannten Metalloxidschicht sollte sie ein- oder zweiseitig an einer Metalloberfläche anliegend hergestellt werden, wobei vorzugsweise dann als Metall dasselbe Metall gewählt wird, aus welchem auch das Oxid der Schicht gebildet wird. Mit für die Entstehung von Mikrorissen verantwortlich ist, wie erwähnt wurde, die Haftung der erfindungsgemäss hergestellten Metalloxidschicht auf der Unterlage, im vorliegenden Falle auf der mindestens einen genannten Metalloberfläche.

Diese Haftung wird bei Vorgehen nach dem Wortlaut von Anspruch 18 wesentlich erhöht.

Gemäss dem Wortlaut von Anspruch 19 wird der Oxidationsgrad der sich aufbauenden Schicht insbesondere durch Konstanthaltung der Unterlagentemperatur sowie durch Stellen der pro Zeiteinheit eingelassenen Sauerstoffmenge in grösseren Stellzeitintervallen durchgeführt, wobei, in einem kleineren Stellzeitraster, die Rate freigesetzter Metallmengen gestellt wird. Dies, weil Stellschritte und Verstellzeiten der freigesetzten Metallrate, insbesondere bei der vorgeschlagenen, noch zu beschreibenden Verdampfungsratenregelung, wesentlich feiner bzw. kürzer sind als Stellzeiten von Gaszuflussregelungen, unter Berücksichtigung ihrer durch Zuleitungen etc. bewirkten Reaktionsträgheiten.

Nach dem Wortlaut von Anspruch 23 kann, als Sauerstoff, angeregter Sauerstoff eingesetzt werden, in Form von Ozon und/oder Sauerstoffmonomer und/oder elektronisch angeregtem Sauerstoff oder von Ionen. Dabei sollte, nach dem Wortlaut von Anspruch 24, die kinetische Energie auch des angeregten Sauerstoffes nicht mehr als 10eV betragen, um damit lediglich die Oxidationsausbeute zu erhöhen und um dabei keine undefinierte Beeinflussung erst der Unterlagen-, dann der Schicht-Oberflächeneigenschaften zu ergeben.

Eine Vakuumbehandlungsanlage zur Ausführung des erläuterten Verfahrens ist nach dem Wortlaut von Anspruch 29 ausgebildet, bevorzugte Ausführungsvarianten dieser Anlage nach den Ansprüchen 30 bis 42.

Nach dem erfindungsgemässen Verfahren bzw. mit der erfindungsgemässen Vakuumbehandlungsanlage können mit unerwartet geringer Ausschussquote erfindungsgemäss beschichtete Teile hergestellt werden. Damit lassen sich gemäss Anspruch 43 mit mindestens einer Metalloxidschicht beschichtete Teile gleichzeitig herstellen, woran bei vorgegebener Flächenausdehnung der einzelnen Teile von mindestens 15mm$^2$ mindestens 30%, vorzugsweise mindestens 40% der Teile höchstens für vorgegebene Ionen selektiv leitend sind und mithin als Sensoren brauchbar sind. Es ergibt sich sogar eine Ausbeute höher als 90%; gleichzeitig wird die Lebensdauer der Teile, beispielsweise als Sensoren eingesetzt, wesentlich erhöht.

Die erwähnten Ausbeuteprozentzahlen beziehen sich auf Flächenausdehnungen der Beschichtung von mindestens 15mm$^2$. So heisst beispielsweise eine Ausbeute von 90%, dass von 1500mm$^2$ beschichteter Fläche 1350mm$^2$ mikrorissfrei sind.

Die Teile können dabei bereits als solche beschichtet werden oder erst als "Gross-Substrat", das nachmals, wie z.B. durch einen Laserschneidprozess, in die einzelnen zu verwendenden Teile unterteilt wird.

Die Erfindung wird anschliessend beispielsweise anhand von Figuren erläutert.

Es zeigen:

Fig. 1      schematisch, und auch zur Erläuterung des erfindungsgemässen Verfahrens, eine Ausführungsvariante einer erfindungsgemässen Vakuumbehandlungsanlage;

Fig. 2      eine weitere Ausführungsvariante des an der Anlage gemäss Fig. 1 eingesetzten Vakuumrezipienten;

Fig. 3      schematisch, jeweils über der Zeitachse, beispielsweise den geregelten oder gesteuerten Verlauf der Rate des freigesetzten, insbesondere durch Elektronenstrahlverdampfen freigesetzten Metalles, der Unterlagentemperatur sowie des Masseflusses eingelassenen Sauerstoffes, letzteres wiederum beispielsweise für das Aufbringen einer erfindungsgemässen Metalloxidschicht auf eine Metallunterlage bzw. das Abdecken der erzeugten Metalloxidschicht, nachfolgend, durch eine Metallabdeckung;

Fig. 4      schematisch und ebenfalls qualitativ, analog zu Fig. 3, beispielsweise den geregelten oder gegebenenfalls gesteuerten Verlauf des Masseflusses eingelassenen Sauerstoffes und des Verlaufes der pro Zeiteinheit freigesetzten Metallmenge bzw. elektronenstrahlverdampften Metallmenge sowie einen beispielsweisen resultierenden Verlauf des Verhältnisses (V) von Sauerstoff-Massefluss und Metallrate, wobei der Sauerstoff-Massefluss in grösseren Zeitintervallen verstellt wird und zum Erhalt des erwünschten Verhältnisses die Metallrate nachgeführt wird;

Fig. 5        schematisch und qualitativ, die Abhängigkeit des Oxidationsgrades vom Massefluss des eingelassenen Sauerstoffes, jeweils bei verschiedenen, konstant gehaltenen Raten freigesetzten Metalles, bei einer gegebenen Anlagekonfiguration;

Fig. 6        eine Darstellung analog zu Fig. 5 des Oxidationsgrades in Funktion der Rate freigesetzten Metalles bei jeweils konstant gehaltenem Massefluss eingelassenen Sauerstoffes;

Fig. 7        schematisch den erfindungsgemässen Aufbau einer erfindungsgemässen Schicht, insbesondere auf einer Metallunterlage, zur Sicherstellung optimaler Schichthaftung;

Fig. 8 und 9    je qualitativ, beispielsweise Verläufe von Sauerstoff-Massefluss, daraus resultierend des Oxidationsgrades bei konstant gehaltener Metallfreisetzungsrate und daraus resultierend das Oxidationsgradprofil über der Dicke der sich aufbauenden erfindungsgemässen Schicht;

Fig. 10       die Verbindung eines Sauerstoffvorrates mit der Vakuumkammer zur Erläuterung von Reinigungszyklen für das Verbindungsleitungssystem zwischen Vorrat und Vakuumkammer.

Anhang A

Da mit Bezug auf eine bevorzugte Ausführungsform des erfindungsgemässen Verfahrens sowie der erfindungsgemässen Anlage, als Metallquelle, ein Elektronenstrahlverdampfer eingesetzt wird und dies zur Erlangung höchster Präzision bezüglich Rateführung, vorzugsweise mittels einer Elektronenstrahlquelle vorgenommen wird, wie sie in den veröffentlichten Druckschriften der Anmelderin DE-OS-39 21 040 sowie 39 29 475 beschrieben ist bzw. nach den dort beschriebenen Regelverfahren, werden diese beiden Schriften hiermit als integrierter Bestandteil der vorliegenden Beschreibung erklärt.

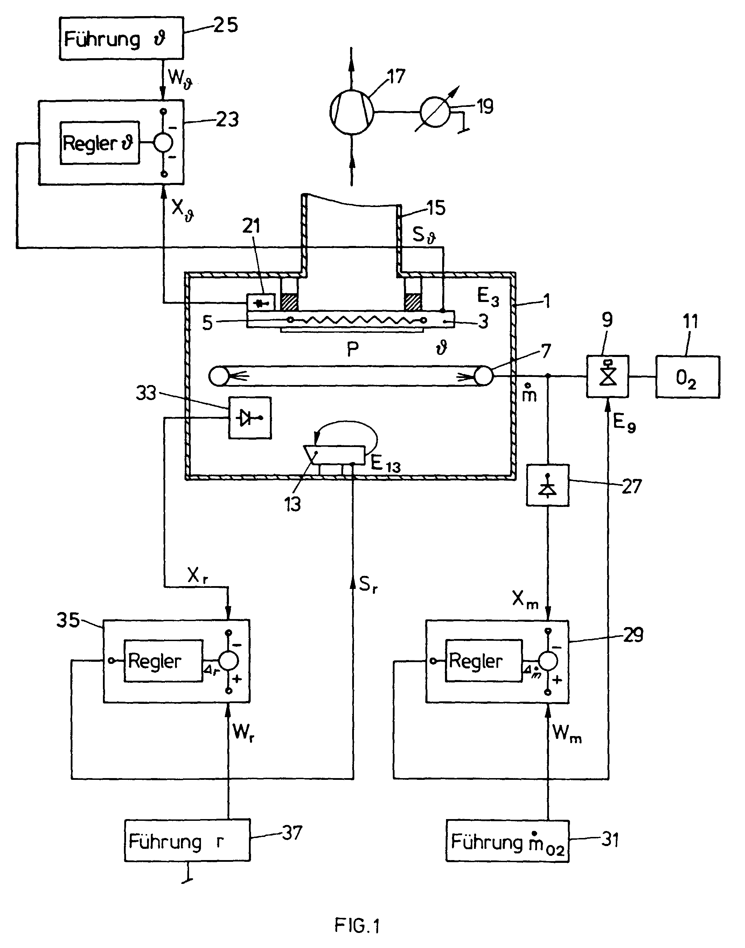

In Fig. 1 ist schematisch eine bevorzugte Ausführrungsvariante einer erfindungsgemässen Vakuumbehandlungsanlage dargestellt, anhand derer auch das erfindungsgemässe Verfahren erläutert werden soll.

In einem Vakuumrezipienten 1, in bekannter Art und Weise aufgebaut, um den Bedingungen des Hochvakuumbereiches bzw. des Ultra-Hochvakuumbereiches zu genügen, ist in bekannter Art und Weise ein beweglicher oder, wie dargestellt, stationärer Werkstückträger 3 vorgesehen. Der Werkstückträger 3 ist, wie mit dem Heizelement 5 schematisch dargestellt, beheizbar. Im Vakuumrezipienten 1 ist, dem Werkstückträger 3 gegenüberliegend, eine Gasbrause 7 vorgesehen, bevorzugterweise ausgebildet als ringförmig umlaufende Gasdusche, wie dargestellt, welche über ein Massefluss-Stellglied 9 mit einem Sauerstoff-Vorratstank 11 verbunden ist. Das Stellglied 9 ist an einem Eingang $E_9$ steuerbar.

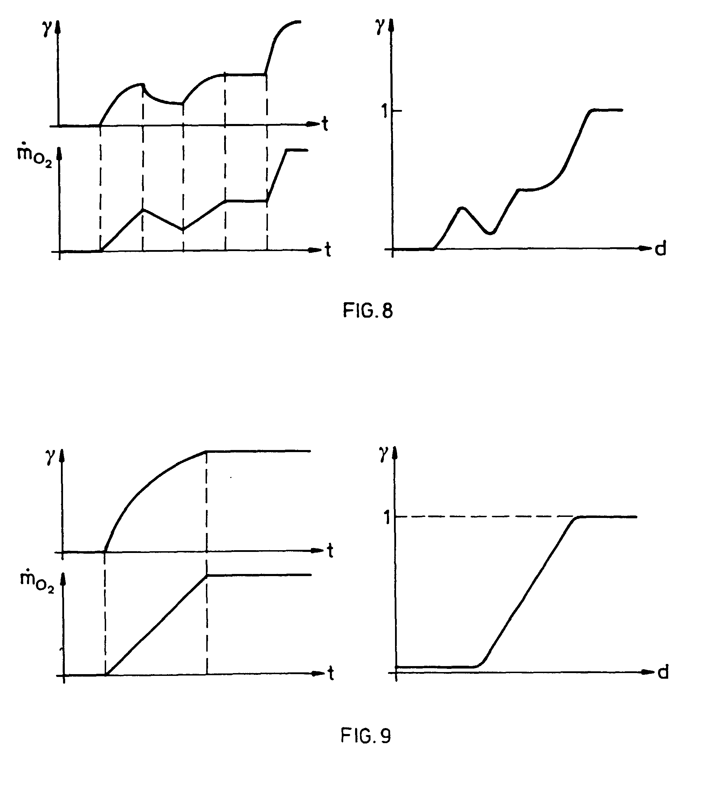

Bezüglich der Gaseinlassanordnung 7, dem Werkstückträger 3 gegenüberliegend, ist eine Elektronenstrahl-Verdampferquelle mit Elektronenstrahl-Erzeuger 13 vorgesehen. Bezüglich des bevorzugten Aufbaues der Elektronenstrahl-Verdampfereinheit wird insbesondere auf Fig. 8 und zugehörige Beschreibung der DE-OS-39 29 475 (Anhang A) verwiesen.

Wesentlich ist, dass die Elektronenstrahl-Verdampfereinheit 13 einen Steuereingang $E_{13}$ aufweist, mittels welchem die Verdampfungsrate r, definiert als proZeiteinheit und über die Freisetzungs- bzw. Verdampfungsoberfläche der Quelle gemittelte verdampfte Metallmenge, genügend rasch und genügend präzise gestellt werden kann, so dass, wie noch zu beschreiben sein wird, diese Rate von abgelegter Molekularschicht zur nächsten nach Wunsch verändert werden kann. Bevorzugterweise kann an der Elektronenstrahl-Verdampfereinheit 13 eine über die Zeit gemittelte Verdampfungsrate von weniger als $0,3 nms^{-1}$, vorzugsweise als $0,1 nms^{-1}$, vorzugsweise als $0,01 nms^{-1}$, gar als $0,005 nms^{-1}$, eingestellt werden, wobei diese Rate selbstverständlich nicht verschwinden darf.

Im weiteren kann an der Elektronenstrahl-Verdampfereinheit 13 eine mittlere Verdampfungsrate mit einer Genauigkeit von $\pm$ 10%, vorzugsweise von höchstens $\pm$ 3%, vorzugsweise gar von höchstens $\pm$ 1%, eingestellt werden. Die Langzeitdrift der an der Elektronenstrahl-Verdampfereinheit 13 einstellbaren mittleren Verdampfungsrate soll deshalb minimal sein, weil die hier angesprochenen Prozesse aufgrund des langsamen Schichtaufbaues relativ langwierige Prozesse sind. Vorzugsweise beträgt diese Drift der gemittelten Rate weniger als 5% des SOLL-Wertes in 20 Minuten, dabei gar vorzugsweise weniger oder gleich 0,5% in einer Stunde.

Wenn von einer zeitlich gemittelten oder mittleren Rate r gesprochen wird, so heisst dies

$$r = \frac{1}{T} \int_{t}^{t+T} r_m(t)\, dt,$$

wobei $r_m$ die momentane Rate bedeutet und T die Mittelungszeit von vorzugsweise 10sec.

Bevorzugterweise auf der Hinterseite des Werkstückträgers 3 ist ein Pumpanschluss 15 zur Evakuierung des Vakuumrezipienten 1 und, gegebenenfalls, mit zur Steuerung des Sauerstoff-Partialdruckes im Prozessraum P vorgesehen. Der Pumpanschluss 15 ist mit einer Vakuumpumpe 17 verbunden, deren Pumpleistung an einer Einheit 19 stellbar ist.

Im Bereiche des Werkstückträgers 3, vorzugsweise am Werkstückträger 3, ist ein Temperatursensor 21 vorgesehen, dessen Ausgangssignal entweder der Ueberwachung der Werkstückträgertemperatur dient oder bevorzugterweise, und wie dargestellt, als Temperatur-IST-Wert-Signal $X\vartheta$ auf einen Regelkreis, schematisch bei 23 dargestellt, geführt ist. Der Temperaturregelkreis 23 wird durch eine Temperaturführungseinheit 25 geführt und wirkt mit einem Stellsignal, entsprechend der verstärkten Regeldifferenz $S\vartheta$ auf den Stelleingang $E_3$ für die Werkstückträgertemperatur $\vartheta$. Die Werkstücktemperatur wird auf höchstens 900°C eingestellt, vorzugsweise auf höchstens 600°C.

Mit der Gaseinlassanordnung 7 ist weiter eine Messfühlereinheit 27 verbunden, mittels welcher der Sauerstoff-Massefluss m gemessen wird. An dessen Statt kann auch der Sauerstoff-Partialdruck in der Kammer gemessen werden. Der in den Rezipienten 1 eingelassene Gasmassefluss m ergibt den Sauerstoff-Partialdruck im Rezipienten nach Massgabe der an der Vakuumpumpe 17 eingestellten Saugleistung sowie nach Massgabe des durch Oxidationsreaktion verbrauchten Sauerstoffes.

Das Ausgangssignal der Sensoreinheit 27 wird mithin entweder zu Steuerzwecken eingesetzt oder, und dies bevorzugterweise und wie dargestellt, als gemessenes Stellgrössensignal $X_m$ einem Regelkreis 29 zugeführt, welcher mit einem Stellsignal $S_m$ auf den Eingang $E_9$ der Stellereinheit 9 wirkt. Mittels einer Durchflussmengen-Führungseinheit 31 wird die dem Rezipienten 1 zugeführte Gasmenge pro Zeiteinheit, der Gasmassefluss m, in regelndem Sinne geführt.

Schliesslich wird eine Metallratemessung vorgenommen. Hierzu wird ein metallselektiver Ratesensor 33 vorgesehen, und zwar bevorzugterweise in einem Winkelbereich, unter welchem ein Werkstück O auf dem Werkstückträger 3 die Metallquelle, mithin die verdampfte Oberfläche - Freisetzungsfläche -, an der Verdampfungseinheit 13 sieht. Der Ratesensor weist bevorzugterweise eine Detektionsempfindlichkeit $\leq 0.01$ nms$^{-1}$ (0,1Ås$^{-1}$) auf, dabei bevorzugterweise gar von $\leq 0.001$ nms$^{-1}$ (0,01Ås$^{-1}$). Aus regeltechnischen Gründen weist weiter der eingesetzte Ratesensor 33 bevorzugterweise eine Ansprechzeit (Schrittantwort) $\leq 100$ms, bevorzugterweise $\leq 10$ms bzw. vorzugsweise gar $\leq 1$ms auf. Letzteres entspricht an einer Anlagekonfiguration wie gezeichnet der Flugzeit von verdampften Metallteilchen mit einer kinetischen Energie $\leq 10$eV, wenn zwischen verdampfter Metalloberfläche und zu beschichtender Werkstückoberfläche ein Abstand von ca. 50cm eingehalten ist.

Um diese Spezifikationen zu erfüllen, wird bevorzugterweise ein Quadrupol-Massenspektrometer als Sensor 33 eingesetzt, wie ein Massenspektrometer QMA400, wie er von der Anmelderin vertrieben wird.

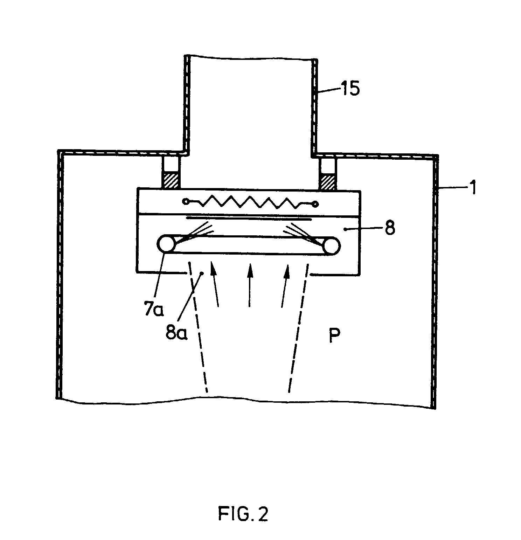

Im weiteren wird bevorzugterweise, und wie anhand von Fig. 2 erläutert werden soll, weitgehendst verhindert, dass der sensible Ratesensor 33 durch Sauerstoffgas beeinflusst wird. Hierzu wird in einer weiteren bevorzugten Ausführungsvariante die Gasdusche 7a innerhalb einer Druckstufenkammer 8 angeordnet, mit Blendenöffnung 8a. Der Druck innerhalb der Druckstufenkammer 8 wird durch Eindüsen des Sauerstoffes gegenüber dem Druck in der übrigen Prozesskammer P erhöht, wobei diese Druckdifferenz, mindestens zum Teil, durch Wirkung der Blende 8a aufgenommen wird. Dadurch wird verhindert, dass wesentliche Mengen Sauerstoff in den Bereich des Sensors 33 gelangen.

Im weiteren wird dadurch auch sichergestellt, dass, wie gestrichelt dargestellt, Metallpartikel und Sauerstoff im wesentlichen getrennt auf die Werkstückoberfläche eintreffen und mithin die Metalloxidschicht in situ, d.h. auf der Oberfläche, gewachsen wird.

Die übrigen in Fig. 1 dargestellten Aggregate sind in Fig. 2 nicht eingetragen.

Die anhand des Sensors 33 gemessene, von den momentanen, über der Verdampfungsoberfläche vorherrschenden Verdampfungsrate abhängige Grösse wird entweder zu Steuerzwecken für die Verdampfungsrate eingesetzt oder, und dies bevorzugterweise und wie dargestellt, als gemessene Regelgrösse $X_r$ einem Regelkreis 35 zugeführt, welch letzterer mit dem Stellsignal $S_r$ am Eingang $E_{13}$ der Elektronenstrahl-Verdampfereinheit 13 die momentane Verdampfungsrate stellt. Der Regelkreis wird mit einer Ratenführungseinheit 37 geführt.

Bezüglich des Aufbaues und der Funktion eines solchen Ratestell- und bevorzugterweise -regelkreises für die hoch präzise Einstellung kleinster Raten an einem Elektronenstrahl-Verdampfer der bevorzugten Aufbauweise wird vollumfänglich auf die DE-OS-39 21 040 mit ihrem ganzen Offenbarungsgehalt für den Fachmann verwiesen (Anhang A).

Die Metallpartikelquelle, wie vorzugsweise ein Elektronenstrahlverdampfer gemäss der DE-OS-39 21 040, weist vorzugsweise Stellzeiten für die Rate von höchstens 100ms, vorzugsweise von höchstens 10ms bzw. gar von höchstens 1ms auf.

An der Anlage, wie sie schematisch in Fig. 1 dargestellt ist, wird ein Verfahren wie folgt vorgenommen: Der Vakuumrezipient 1 wird mittels der Vakuumpumpe 17 auf Hochvakuum, vorzugsweise Ultra-Hochvakuum, evakuiert, d.h. auf einen Startdruck $\leq 10^{-6}$ mbar, dabei bevorzugterweise $\leq 10^{-9}$ mbar. Dadurch wird die Verunreinigung des nachmals zugeführten Prozessgases, des Sauerstoffes, durch Restgas minimalisiert.

Mit der Elektronenstrahl-Verdampfereinheit 13 wird Metall verdampft und, über die Gaseinlassanordnung 7 bzw. 7a, Sauerstoff in den Vakuumrezipienten 1 eingelassen. Dabei wird das Verhältnis der pro Zeiteinheit eingelassenen Sauerstoffmenge, d.h. der Sauerstoff-Massefluss m, zu der pro Zeiteinheit verdampften gemittelten Metallmenge, deren Rate r, so gewählt, dass das abgedampfte Metall bevorzugterweise vornehmlich auf der Unterlage, d.h. der zu beschichtenden Werkstückoberfläche O homogen verteilt, mit vorgegebenem Oxidationsgrad, oxidiert. Dabei wird die Unterlagentemperatur $\vartheta$ minimal, vorzugsweise unterhalb 900°, vorzugsweise dabei unterhalb oder gleich 600°, gehalten.

Mit Iridium als Metall wurden bei den folgenden Verhältnissen des Verfahrens ausgezeichnete Resultate erzielt:

Anlage gemäss Fig. 1 mit oben erwähnter, bevorzugter Elektronenstrahl-Verdampfereinheit und bevorzugter Rateregelung sowie mit 50cm Werkstückoberfläche-Verdampfungsflächen-Abstand:

über 10s gemittelte Verdampfungsrate des Metalles r: $\leq 0{,}3 \text{nms}^{-1}$,

$O_2$-Partialdruck im Prozessraum P am Unterlagenbereich: $\leq 8 \cdot 10^{-4}$ mbar.

Vier von zehn ca. $15\text{mm}^2$ grosse beschichtete Teile konnten anschliessend als elektrochemische Sensoren eingesetzt werden.

Dabei wurde bei der Schichtherstellung der Partialdruck des Sauerstoffes und mithin m während des Beschichtungsprozesses konstant gehalten, ebenso die Rate r.

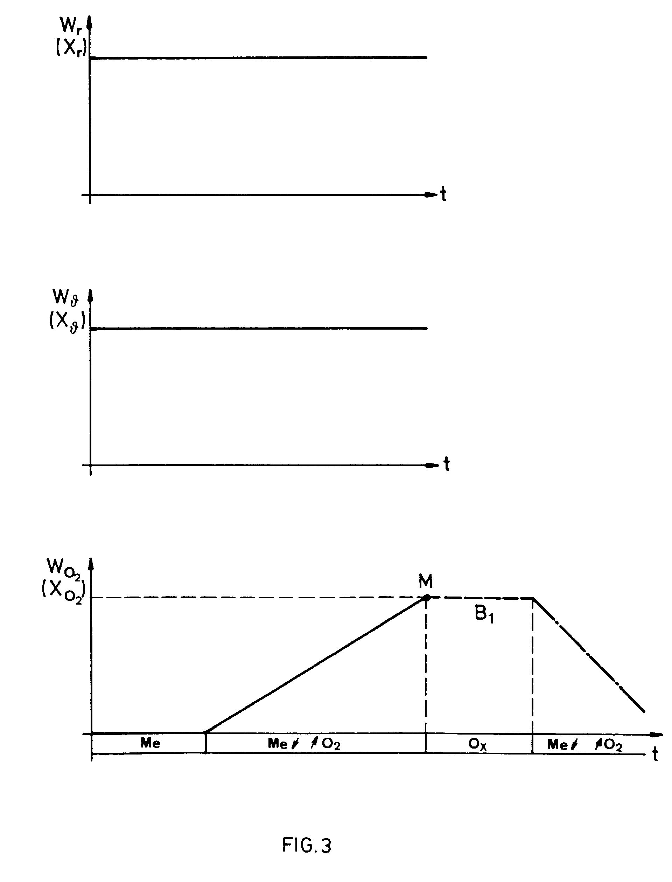

Erfindungsgemäß wurde eine weitere Verbesserung der Schichtherstellung, wie dies anhand von Fig. 3 erläutert werden soll, erzielt. Unter den obgenannten Bedingungen wurde eine $Ir_2O_3$-Schicht auf eine Ir-Unterlage aufgedampft, dies einerseits, anderseits auf eine Saphirunterlage. Dabei wurde, wie in Fig. 3 dargestellt, die Verdampfungsrate r konstant geregelt und ebenso die Temperatur der Schichtunterlage, wie bereits im oben erwähnten Beispiel, auf 600°C.

Es wurde nun vorerst, wie schematisch am Verlauf des Sauerstoff-Masseflusses in Fig. 3 dargestellt, kein Sauerstoff in den Vakuumrezipienten 1 gemäss Fig. 1 eingelassen. Mithin wurde vorerst auf das Saphirsubstrat bzw. das Iridiumsubstrat eine Metallschicht aufgewachsen. Darnach wurde m während einer vorgegebenen Zeit, während 50min, erhöht, und zwar stetig, in Form einer Rampe. Nach Beendigung der Erhöhung des Sauerstoff-Masseflusses m gemäss Punkt M von Fig. 3 wurde nachfolgend während mindestens 1000sec mit erwünschtem, konstantem Oxidationsgrad weiter beschichtet.

Als Resultat zeigte sich, dass 100% der wiederum ca. $15\text{mm}^2$ grossen beschichteten Teile als elektrochemische Sensoren eingesetzt werden konnten. Die Schichthaftung wurde mit dem Klebebandtest überprüft: Die aufgebaute Schicht lässt sich nur mit der Reissnadel entfernen. Dies sowohl auf der Saphirunterlage wie auch auf der Metallunterlage.

Eine Verkürzung der Rampendauer kann aus prozesstechnischen Gründen, nämlich Zeit und Durchsatz, verkürzt werden, bis auf ca. 5min. Die Minimalgrösse ist bei jedem Metall/Metalloxid-Schichtsystem, das erfindungsgemäss hergestellt wird, experimentell zu ermitteln. Aufgrund des realisierten Oxidationsgradprofiles war die Lebensdauer der elektrochemischen Sensorteile gegenüber derjenigen ohne Oxidationsgradprofil drastisch erhöht. Soll, wie aus Fig. 3 ebenfalls ersichtlich, anschliessend an die erfindungsgemäss hergestellte Metalloxidschicht wiederum eine Metallschicht abgelegt werden, so wird der Oxidationsgrad wieder stetig reduziert durch vorzugsweise rampenförmige Abnahme des Sauerstoff-Masseflusses m, womit der Schichtaufbau wiederum mehr und mehr metallisch wird.

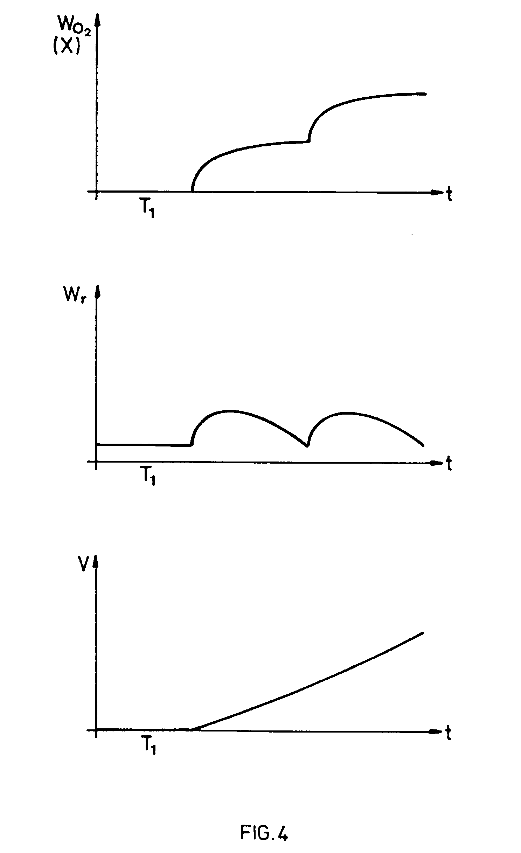

In Fig. 4 ist eine weitere Variante der Prozessführung schematisch dargestellt. Hier wird vorerst in einer ersten Zeitphase $T_1$ beispielsweise auf eine Metallunterlage Metall abgeschieden. Hierzu wird eine entsprechende Verdampfungsrate r eingestellt und kein Sauerstoff eingelassen. Darnach wird der Sauerstoff-Massefluss (entsprechend seiner Führungsgrösse $W_{O2}$) in einem Schritt erhöht. Es ist, qualitativ übertrieben, die Trägheit dargestellt, mit welcher der Sauerstoff-Massefluss und insbesondere der Partialdruck im Rezipienten auf einen Steuerschritt reagiert. Die Rate verdampften Materials wird entsprechend ihrer Führungsgrösse $W_r$ so geführt, dass nach Massgabe des jeweils vorherrschenden, momentanen Sauerstoff-Masseflusses ein erwünschtes momentanes Sauerstoff- zu Metall-Verhältnis an der zu beschichtenden Oberfläche vorherrscht, um momentan den erwünschten Oxidationsgrad zu erzielen. Hierzu wird die Rate r in Abhängigkeit von m geführt.

Auch auf diese Art und Weise kann eine stetige Zunahme des Oxidationsgrades, entsprechend einer stetigen Zunahme des Sauerstoff- zu Metall-Verhältnisses, erreicht werden, wobei aber dieses Verfahren insbesondere dann eingesetzt wird, wenn ein erwünschtes Oxidationsgradprofil nicht durch stetige Aenderung des Sauerstoff-Masseflusses realisierbar ist oder nicht durch alleiniges Aendern dieses Masseflusses in relativ grossen Zeitabschnitten. Dies deshalb, weil eine rasche Aenderung des Sauerstoff-Masseflusses aufgrund der Trägheit, mit welcher letzterer auf Führungsgrössenänderungen reagiert, nicht in dem Masse möglich ist wie eine rasche und präzise regeltechnische Führung der Rate verdampften Metalles.

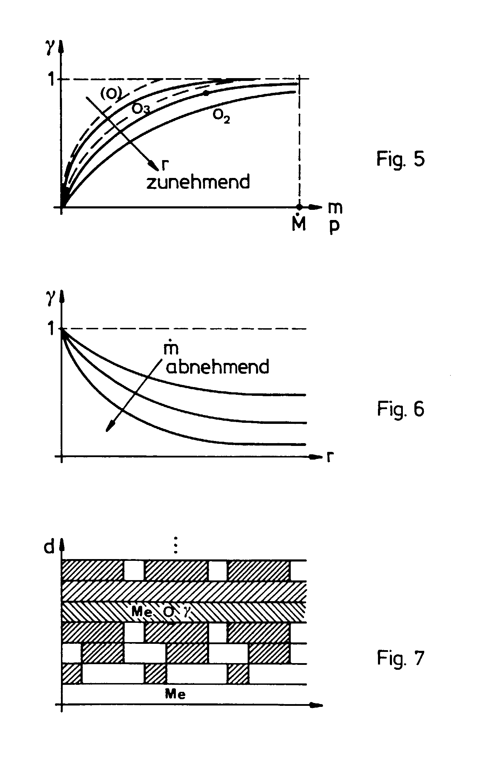

In Fig. 5 ist schematisch die Abhängigkeit des Oxidationsgrades vom Sauerstoff-Massefluss m dargestellt. Dies bei unterschiedlichen, jeweils konstant gehaltenen Metallverdampfungsraten r und bei konstant gehaltener Saugleistung und Unterlagentemperatur. Daraus ist ersichtlich, dass mit zunehmendem Sauerstoff-Massefluss m der Reaktionsgrad gegen den Wert 1 läuft, und zwar desto schneller, je geringer die jeweils konstant gehaltene Verdampfungsrate r ist.

Betrachtet man bei konstant gehaltener Verdampfungsrate r einen Verlauf, wie beispielsweise bei $O_2$ dargestellt, so ergibt sich interessanterweise bei den gleichen Verhältnissen, aber Zuführung angeregten Sauerstoffes O bzw. $O_3$, dank der höheren Oxidationsausbeute bereits bei niedrigeren Reaktivgasflüssen m, eine gesättigte Oxidation. Daraus ist ersichtlich, dass eine Möglichkeit, die Metallverdampfungsrate r zu erhöhen, um erfindungsgemäss Schichten rascher aufzubauen, darin besteht, die Reaktivität des Sauerstoffes durch Zuführen angeregten Sauerstoffes zu erhöhen. Auch durch selektive Zuführung unterschiedlich angeregten Sauerstoffes wird es möglich, ein Oxidationsgradprofil zu führen.

In Fig. 6 ist analog zu Fig. 5 die Abhängigkeit des Oxidationsgrades von der Verdampfungsrate r dargestellt, mit je konstant gehaltenen Sauerstoff-Masseflüssen m.

In Fig. 7 ist eine bevorzugte erfindungsgemässe Schicht in ihrem Aufbau dargestellt, wie sie bei Vorgehen nach den Fig. 3 oder 4 oder durch Steuerung des Anteils angeregten Sauerstoffes realisiert wird. Es bedeuten dabei, rein qualitativ, die dunkeln Bereiche die oxidischen Lageanteile. Daraus ist ersichtlich, dass ein stetiger Oxidationsgradübergang zwischen Metallschicht und Metalloxidschicht mit erwünschtem Oxidationsgrad erfolgt, was, wie gezeigt wurde, die Haftung der Schicht an der Unterlage ganz wesentlich erhöht. Es ist dargestellt, wie bei bevorzugter erfindungsgemässer Steuerung des Oxidationsgradprofiles zwischen metallischer und oxidischer Domäne sich von Monolage zu Monolage der Oxidationsgrad ändert.

Dieser perkolative Effekt ermöglicht es, dass die so aufgebaute Schicht sowohl Druck- wie auch Schubspannungen in wesentlich erhöhtem Masse aufnehmen kann.

Obwohl das oben aufgeführte Beispiel davon ausgeht, auf einer Metallschicht erfindungsgemäss eine Metalloxidschicht desselben Metalles aufzubringen, ist es durchaus möglich, Metallschicht und Metalloxidschicht von unterschiedlichen Metallen herzustellen bzw. die Metalloxidschicht auf eine nicht metallische Unterlage, wie gezeigt wurde, Saphir, erfindungsgemäss aufzubringen.

In den Fig. 8 und 9 ist dargestellt, wie gezielt, zum Erhalt von Schichten mit erwünschtem Oxidationsgradprofil über ihre Dicke d, die Sauerstoffzuführung entsprechend m über der Zeit t und damit die Verteilung des Oxidationsgrades über der Zeit geführt wird.

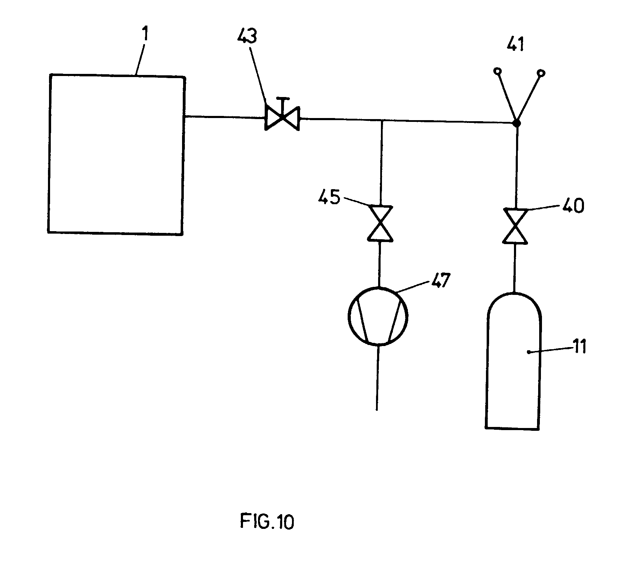

Gemäss Fig. 10, welche einen bevorzugten Zusatz zur Anlage nach Fig. 1 zeigt, ist der Sauerstofftank bzw. -vorrat 11 über ein erstes Ventil 40, ein Manometer 41, ein zweites Ventil, nämlich ein Drosselventil 43, auf den Rezipienten 1, wie in Fig. 1 dargestellt, geführt. Zwischen dem ersten und zweiten Ventil 40, 43 zweigt, über ein drittes Ventil 45, ein Pumpanschluss mit einer Pumpe 47 ab. Diese Anordnung dient dem Anschliessen des Sauerstoffvorrates 11. Der Raum zwischen den Ventilen 43, 45 und 40 ist, vor Anschliessen des Tankes 11, belüftet. Darnach wird der Tank 11 installiert, die Ventile 40, 43, 45 sind geschlossen. Darnach wird Ventil 45 geöffnet, und es wird mittels der Pumpe 47 evakuiert, auf einen Enddruck $\leq 10^{-2}$ mbar, vorzugsweise $\leq 10^{-7}$ mbar. Gleichzeitig wird bevorzugterweise das Leitungssystem zwischen den Ventilen 40, 43, 45 beheizt, vorzugsweise auf mindestens 200°C. Nach Evakuieren des Leitungsraumes wird das Ventil 45 geschlossen und Gas aus dem Tank 11, nach Oeffnen des Ventils 40, in den Leitungsraum zwischen den Ventilen 43 und 45 expandiert. Darauf wird das Ventil 40 geschlossen, Ventil 45 geöffnet und dieser Zyklus bevorzugterweise mehrmals, vorzugsweise mindestens fünfmal wiederholt, bevor der Sauerstoffvorrat 11, nach Schliessen des Ventils 45, über die Ventile 40 und 43 gesteuert mit dem Vakuumrezipienten 1 verbunden wird.

Damit wird vermieden, dass die erfindungsgemäss vorgenommene Beschichtung durch Verunreinigungen aus dem erwähnten Leitungssystem ungewollt dotiert wird.

Nach dem erfindungsgemässen Vorgehen wurden im weiteren $SiO_2$-Schichten auf Si aufgewachsen. Die gemessene Verdampfungsrate entsprach einem Schichtwachstum auf der Unterlage von weniger als 0.05 $nms^{-1}$ (0,5$Ås^{-1}$), was weniger als 0,1 Monolagen pro Sekunde entspricht. Damit wurde pro Monolage eine Beschichtungszeit von 10s erreicht. Die zeitlich gemittelte Rate schwankte weniger als $\pm$ 1%. Bei konstant gehaltenem Sauerstoff-Massefluss konnten mithin Monolagen mit einer Oxidationsgradpräzision von $\pm$ 1% geregelt hergestellt werden.

**Patentansprüche**

1. Verfahren zur Herstellung einer Metalloxidschicht auf einer Unterlage, bei welchem eine Vakuumkammer mindestens auf Hochvakuum-Druckbereich evakuiert wird und Metall in die Vakuumkammer freigesetzt wird, in welche Sauerstoff eingelassen wird, und bei dem die Unterlagstemperatur unter 900°C gehalten wird, dadurch gekennzeichnet, dass zur Herstellung höchstens für Ionen vorgegebener Gattung selektiv durchleitender Schichten die kinetische Energie gegen die Unterlage auftreffender, freigesetzter Metallpartikel höchstens 10eV beträgt und der Oxidationsgrad der Schicht, ausgehend von der Unterlage mit einem zeitlichen Steuerstellraster entsprechend höchstens der Ablagezeit jeweils einer monoatomaren bzw. monomolekularen Schicht erhöht wird.

2. Verfahren nach Anspruch 1, dadurch gekennzeichnet, dass das Metall so in die Kammer freigesetzt wird, dass die in der Zeit und über die Freisetzungsfläche gemittelte Freisetzungsrate von einer Metallpartikelquelle nicht mehr als $0,3nms^{-1}$, vorzugsweise als $0,1nms^{-1}$, vorzugsweise als $0,01nms^{-1}$, gar als $0,005nms^{-1}$, beträgt.

3. Verfahren nach einem der Ansprüche 1 oder 2, dadurch gekennzeichnet, dass die Genauigkeit der über die Zeit und eine Freisetzungsfläche gemittelten Freisetzungsrate des Metalles von einer Metallquelle, bezogen auf einen SOLL-Wert, $\leq 10\%$, vorzugsweise $\leq 1\%$ ist.

4. Verfahren nach einem der Ansprüche 1 bis 3, dadurch gekennzeichnet, dass die Drift der zeitlich und über die Freisetzungsfläche gemittelten Freisetzungsrate des Metalles von einer Metallquelle $\leq 5\%$ in 20 Minuten ist, vorzugsweise $\leq 0,5\%$ in einer Stunde.

5. Verfahren nach einem der Ansprüche 1 bis 4, dadurch gekennzeichnet, dass die Unterlage bzw. die sich daran aufbauende Schicht mit dem Sauerstoff und den Metallpartikeln im wesentlichen unreagiert beaufschlagt wird und die Metalloxidschicht in situ gewachsen wird.

6. Verfahren nach einem der Ansprüche 1 bis 5, dadurch gekennzeichnet, dass das Metall verdampft, vorzugsweise elektronenstrahlverdampft wird.

7. Verfahren nach einem der Ansprüche 1 bis 6, dadurch gekennzeichnet, dass die Rate von einer Metallquelle freigesetzten Metalles gemessen wird.

8. Verfahren nach Anspruch 7, dadurch gekennzeichnet, dass die Messung mittels eines Quadrupol-Massenspektrometers erfolgt, z.B. mittels eines QMA400-Massenspektrometers, wie er von der Anmelderin vertrieben wird.

9. Verfahren nach einem der Ansprüche 7 oder 8, dadurch gekennzeichnet, dass die Messung der Rate freigesetzten Metalles als IST-Wert-Messung in einem Regelkreis für die Rate freigesetzten Metalles eingesetzt wird und mit der Führungsgrösse des Regelkreises die erwähnte Rate und damit der Oxidationsgrad an der sich aufbauenden Schicht mindestens mit gestellt wird.

10. Verfahren nach einem der Ansprüche 7 bis 9, dadurch gekennzeichnet, dass zur Messung der Rate ein materialselektiver Ratesensor mit einer Detektionsempfindlichkeit $\leq 0.01$ $nms^{-1}$ $(0,1Ås^{-1})$ eingesetzt wird, bevorzugterweise mit einer Detektionsempfindlichkeit $\leq 0.001$ $nms^{-1}$ $(0,01Ås^{-1})$, bezogen auf die Freisetzung der Metallpartikel an der Metallquelle.

11. Verfahren nach einem der Ansprüche 7 bis 10, dadurch gekennzeichnet, dass zur Messung der Rate ein Ratesensor mit einer Ansprechzeit $\leq 100ms$, bevorzugterweise $\leq 10ms$, bevorzugterweise $\leq 1ms$ eingesetzt wird.

12. Verfahren nach Anspruch 7, dadurch gekennzeichnet, dass die Messung im Raumwinkelbereich erfolgt, unter welchem die Unterlage mit ihrem zu beschichtenden Bereich die Quelle des freigesetzten Metalles sieht.

13. Verfahren nach einem der Ansprüche 1 bis 12, dadurch gekennzeichnet, dass die Vakuumkammer auf UHV(Ultra-Hochvakuum)-Restgas-Druckbereich evakuiert wird.

14. Verfahren nach einem der Ansprüche 1 bis 13, dadurch gekennzeichnet, dass als Prozessanfangsdruck die Vakuumkammer auf mindestens $10^{-6}$ mbar, bevorzugterweise auf mindestens $10^{-9}$ mbar evakuiert wird.

15. Verfahren nach einem der Ansprüche 7 bis 14, dadurch gekennzeichnet, dass ein zur Messung der freigesetzten Metallrate verwendeter Ratesensor so positioniert ist, dass er von der gleichzeitigen Anwesenheit von Sauerstoff in der Vakuumkammer im wesentlichen nicht beeinflusst wird, dass vorzugsweise Unterlagen und Sauerstoffeinlass über eine Druckstufe vom übrigen Teil der Vakuumkammer abgetrennt werden und im genannten übrigen Teil Metallquelle mit Ratesensor angeordnet werden.

16. Verfahren nach einem der Ansprüche 1 bis 15, dadurch gekennzeichnet, dass mindestens eine der folgenden Grössen geregelt wird:

   - Temperatur der Unterlage,

   - freigesetzte Metallmenge pro Zeiteinheit,

   - eingelassene Sauerstoffmenge pro Zeiteinheit bzw. Verhältnis freigesetzter Metallmenge zu eingelassener Sauerstoffmenge je pro Zeiteinheit.

17. Verfahren nach einem der Ansprüche 1 bis 16, dadurch gekennzeichnet, dass zwei der drei Grössen Unterlagentemperatur, Menge des pro Zeiteinheit eingelassenen Sauerstoffes, Rate der freigesetzten Metallmenge, mindestens jeweils während vorgegebener Beschichtungszeitabschnitte konstant gehalten werden, vorzugsweise die Unterlagentemperatur und entweder die Menge pro Zeiteinheit eingelassenen Sauerstoffes oder die Metallmenge pro Zeiteinheit, und dass die dritte Grösse jeweils geführt wird.

18. Verfahren nach einem der Ansprüche 1 bis 17, dadurch gekennzeichnet, dass die Schicht ein- oder zweiseitig an einer Metalloberfläche anliegend hergestellt wird und hierzu, ausgehend vom Metallbeschichten, ein von der Metallunterlage zunehmender, vorzugsweise stetig zunehmender Oxidationsgrad gestellt wird bzw. gegen eine noch vorzunehmende Metallbeschichtung hin ein abnehmender, vorzugsweise stetig abnehmender Oxidationsgrad.

19. Verfahren nach einem der Ansprüche 1 bis 18, dadurch gekennzeichnet, dass entlang der Schichtdicke die Oxidationsgradverteilung durch zeitabhängige Führung mindestens einer der drei Grössen, Temperatur der Unterlage, Rate der freigesetzten Metallmenge, eingelassene Sauerstoffmenge pro Zeiteinheit, gesteuert wird, vorzugsweise die Unterlagentemperatur konstant gehalten wird und eingelassene Sauerstoffmenge pro Zeiteinheit sowie Rate freigesetzten Metalles geführt werden, dabei vorzugsweise die Menge eingelassenen Sauerstoffes in Stellschritten mit grösseren Zeitintervallen, hingegen die Rate freigesetzten Metalles mit einem kleineren Stellzeitraster.

20. Verfahren nach einem der Ansprüche 1 bis 19, dadurch gekennzeichnet, dass die Unterlagentemperatur auf maximal 600°C gehalten wird.

21. Verfahren nach einem der Ansprüche 1 bis 20, dadurch gekennzeichnet, dass, ausgehend von der Unterlage, die Metalloxidschicht mit einem erwünschten Oxidationsgradprofil aufgebaut wird, indem eine konstante Rate freigesetzten Metalles eingestellt wird und die Menge zugeführten Sauerstoffes so stetig erhöht wird, dass sich nach Massgabe der Metallfreisetzungsrate der Reaktionsgrad von abgelegter, monomolekularer Schicht zur nächsten in vorgebbarer Weise verändert.

22. Verfahren nach einem der Ansprüche 1 bis 21, dadurch gekennzeichnet, dass ein Raum, an welchem Sauerstoff eingelassen wird, mit der Unterlage über eine Druckstufe vom übrigen Prozessraum abgetrennt wird.

23. Verfahren nach einem der Ansprüche 1 bis 22, dadurch gekennzeichnet, dass der angeregte Sauerstoff in Form von Ozon und/oder Sauerstoffmonomeren und/oder elektronisch angeregtem Sauerstoff und/oder von Ionen zugeführt wird.

24. Verfahren nach einem der Ansprüche 1 bis 23, dadurch gekennzeichnet, dass die kinetische Energie des Sauerstoffes oder des angeregten Sauerstoffes nicht höher als 10eV ist.

25. Verfahren nach einem der Ansprüche 1 bis 24, dadurch gekennzeichnet, dass der Sauerstoff durch eine Glimmentladung, eine Mikrowellenentladung, induktiv gekoppeltes Plasma und/oder Lichtstrahlung, insbesondere UV-Strahlung, angeregt wird.

26. Verfahren nach einem der Ansprüche 1 bis 25, dadurch gekennzeichnet, dass ein Sauerstoffvorrat über ein erstes Ventil vorratseitig und ein zweites Ventil kammerseitig mit der Vakuumkammer verbunden wird, zwischen dem ersten und zweiten Ventil über ein drittes Ventil eine Pumpe angeschlossen wird und vorzugsweise unter Aufheizen des Leitungssystems zwischen den drei Ventilen, vorzugsweise auf mindestens 200°C, bei geschlossenem ersten und zweiten Ventil und geöffnetem dritten Ventil, das Leitungssystem evakuiert wird auf mindestens $10^{-2}$mbar, bevorzugterweise auf mindestens $10^{-7}$mbar, darnach das dritte Ventil geschlossen wird, das erste geöffnet wird und mit Sauerstoff geflutet wird, und dieser Zyklus vorzugsweise mindestens fünfmal durchgeführt wird, nach dem letzten Fluten wiederum durch Schliessen des ersten Ventils und Oeffnen des dritten das Leitungssystem mit der Pumpe evakuiert wird und erst darnach das zweite Ventil geöffnet wird.

27. Verfahren nach einem der Ansprüche 1 bis 26, dadurch gekennzeichnet, dass als Metall Ir freigesetzt, vorzugsweise elektronenstrahlverdampft wird.

28. Verfahren nach einem der Ansprüche 1 bis 27, dadurch gekennzeichnet, dass die Menge freigesetzten Metalles mit Stellzeiten von ≤ 100ms, vorzugsweise von ≤ 10ms, vorzugsweise von ≤ 1ms verstellt wird.

29. Vakuumbehandlungsanlage zur Ausführung des Verfahrens nach einem der Ansprüche 1 bis 28 mit einer mindestens zur HV-Applikation aufgebauten Vakuumkammer (1) mit Pumpaggregat (17) einer mit einem Sauerstoffvorrat (11) verbundenen Gaseinlassanordnung (7) mit Durchfluss-Stelleranordnung (9), einer beheizbaren Werkstückträgeranordnung (3) mit Temperatur-stelleranordnung (5) sowie mindestens einer Metallpartikelquelle (13) mit Stellgliedanordnung ($E_{13}$) für die pro Zeiteinheit durch die Quelle freigesetzte Metallpartikelmenge, dadurch gekennzeichnet, dass ein Ratesensor für die Messung der pro Zeiteinheit freigesetzten Metallpartikelmenge vorgesehen ist mit einer Detektionsempfindlichkeit von mindestens 0.01 nms$^{-1}$

(0,1Å sec$^{-1}$) und einer Ansprechzeit von höchstens 100msec und dass der Sensor (33) in einem Regelkreis als IST-Wertaufnehmer geschaltet ist und die Metallpartikelquelle darin als Stellglied, wobei der Regelkreis eine über die Zeit und die Freisetzungsfläche der Quelle gemittelte Freisetzungsrate sicherstellt, die höchstens 10% von einer SOLL-Wertvorgabe abweicht.

30. Anlage nach Anspruch 29, dadurch gekennzeichnet, dass die Vakuumkammer (1) für UHV-Applikationen ausgelegt ist.

31. Anlage nach einem der Ansprüche 29 oder 30, dadurch gekennzeichnet, dass die Metallpartikelquelle eine Verdampfungsquelle, vorzugsweise eine Elektronenstrahl-Verdampfungsquelle ist.

32. Anlage nach einem der Ansprüche 29 bis 31, dadurch gekennzeichnet, dass die Metallpartikelquelle für die Abgabe von Metallpartikeln mit einer über die Zeit und über ihre Freigabefläche gemittelten Rate von bis zu mindestens 0,3nms$^{-1}$, vorzugsweise von mindestens 0,1nms$^{-1}$, vorzugsweise von mindestens 0,01nms$^{-1}$, gar von mindestens 0,005nms$^{-1}$ ausgelegt ist.

33. Anlage nach einem der Ansprüche 29 bis 32, dadurch gekennzeichnet, dass die zeitliche Drift der über die Zeit und die Freisetzungsfläche gemittelten freigesetzten Metallpartikelmenge an der Quelle $\leq$ 5% in 20min, vorzugsweise $\leq$ 0,5% in 1h, bezogen auf den SOLL-Wert, ist.

34. Anlage nach einem der Ansprüche 29 bis 33, dadurch gekennzeichnet, dass der Ratesensor in einem Raumwinkelbereich in der Vakuumkammer angeordnet ist, unter welchem mindestens ein wesentlicher Teil des Werkstückträgers die Freisetzungsfläche der Metallpartikelquelle sieht.

35. Anlage nach einem der Ansprüche 29 bis 34, dadurch gekennzeichnet, dass die Detektionsempfindlichkeit höchstens 0.001 nms$^{-1}$ (0,01Ås$^{-1}$) ist.

36. Anlage nach einem der Ansprüche 29 bis 35, dadurch gekennzeichnet, dass die Ansprechzeit höchstens 10ms, vorzugsweise höchstens lms beträgt.

37. Anlage nach einem der Ansprüche 29 bis 36, dadurch gekennzeichnet, dass die Werkstückträgeranordnung und die Gaseinlassanordnung innerhalb einer Druckstufenkammer angeordnet sind, die über mindestens eine Blende mit dem weiteren Innenraum der Vakuumkammer (1) verbunden ist, und dass vorzugsweise der Sensor zur Messung der Rate in der Vakuumkammer ausserhalb der Druckstufenkammer angeordnet ist.

38. Anlage nach einem der Ansprüche 29 bis 37, dadurch gekennzeichnet, dass in der Kammer ein Quadrupol-Massenspektrometer, wie ein von der Anmelderin vertriebenes QMA400, zur Messung der von der Partikelquelle freigesetzten Metallpartikelrate vorgesehen ist.

39. Anlage nach einem der Ansprüche 29 bis 38, dadurch gekennzeichnet, dass die Durchfluss-Stelleranordnung und/oder die Temperatur-Stelleranordnung und/oder das Ratenstellglied Stelleranordnung eines jeweiligen Regelkreises bilden.

40. Anlage nach einem der Ansprüche 29 bis 39, dadurch gekennzeichnet, dass die Durchlass-Stelleranordnung mit einer Steuereinheit (31) verbunden ist, womit, in Funktion der Zeit, die Durchflussmenge an Sauerstoff nach einem vorgebbaren Zeitverlauf gesteuert oder geregelt wird.

41. Anlage nach einem der Ansprüche 29 bis 40, dadurch gekennzeichnet, dass die Gaseinlassanordnung über ein erstes Ventil und ein zweites Ventil mit dem Sauerstoffvorrat verbunden ist und zwischen diesen Ventilen, über ein drittes Ventil, eine Pumpe angeschlossen ist.

42. Anlage nach einem der Ansprüche 29 bis 41, dadurch gekennzeichnet, dass die Metallpartikelquelle mit Stellzeiten von $\leq$ 100ms, vorzugsweise von $\leq$ 10ms, vorzugsweise gar von $\leq$ 1ms bezüglich der Freisetzungsrate, stellbar ist.

43. Mit mindestens einer Metalloxidschicht beschichteter Teil, dadurch gekennzeichnet, dass bei einer Flächenrasterung von mindestens 15$^2$mm Rasterfläche mindestens 30% der Rasterfläche mikrorissfrei und höchstens für vorgegebene Ionen selektiv durchlässig ist und der Oxidationsgrad in der Schicht und betrachtet in Dickenausdehnungsrichtung der Schicht von der Unterlage über einen vorgegebenen Dickenbereich stetig zunimmt.

44. Teil nach Anspruch 43, dadurch gekennzeichnet, dass mindestens 90% der Fläche höchstens für vorgegebene Ionen selektiv durchlässig ist.

## Claims

1. Process for the production of a metal oxide layer on a substrate, in which a vacuum chamber is evacuated at least to the high-vacuum pressure range and metal is released into the vacuum chamber, into which oxygen is admitted, and in which the substrate temperature is maintained below 900°C, characterised in that, in order to produce layers which are selectively conductive at most for ions of a predetermined type, the kinetic energy of the released metal particles striking the substrate is at most 10eV and the degree of oxidation of the layer is increased departing from the substrate with a time control pattern corresponding at most to the deposition time of a monoatomic or a monomolecular layer.

2. Process according to claim 1, characterised in that the metal is released into the chamber in such a manner that the averaged release rate from a metal particle source over time and over the release area is no more than $0.3\ nms^{-1}$, preferably no more than $0.1\ nms^{-1}$, preferably no more than $0.01\ nms^{-1}$, or even no more than $0.005\ nms^{-1}$.

3. Process according to one of claims 1 or 2, characterised in that the accuracy of the averaged release rate of the metal from a metal source over time and over a release area in relation to a desired value is $\leq 10\ \%$, preferably $\leq 1\ \%$.

4. Process according to one of claims I to 3, characterised in that the drift of the averaged release rate of the metal from a metal source over time and over the release area is $\leq 5\ \%$ in 20 minutes, preferably $\leq 0.5\ \%$ in one hour.

5. Process according to one of claims 1 to 4, characterised in that the oxygen and the metal particles are applied to the substrate or the layer forming thereon in a substantially unreacted state and the metal oxide layer is grown in situ.

6. Process according to one of claims 1 to 5, characterised in that the metal is evaporated, preferably electron-beam evaporated.

7. Process according to one of claims 1 to 6, characterised in that the rate of the metal released from a metal source is measured.

8. Process according to claim 7, characterised in that the measurement is effected by means of a quadrupole mass spectrometer, e.g. by means of a QMA400 mass spectrometer, as sold by the Applicant.

9. Process according to one of claims 7 or 8, characterised in that the measurement of the rate of the released metal is used as an actual-value measurement in a control circuit for the rate of the released metal and the aforementioned rate and therefore the degree of oxidation of the layer being formed at least are controlled by the reference variable of the control circuit.

10. Process according to one of claims 7 to 9, characterised in that the rate is measured by a material selective rate sensor with detection sensitivity of $\leq 0.01\ nms^{-1}$ ($0.1\ Ås^{-1}$), preferably with detection sensitivity of $\leq 0.001\ nms^{-1}$ ($0.01\ Ås^{-1}$), in relation to the release of the metal particles at the metal source.

11. Process according to one of claims 7 to 10, characterised in that the rate is measured by a rate sensor with a response time of $\leq 100$ ms, preferably $\leq 10$ ms, preferably $\leq 1$ ms.

12. Process according to claim 7, characterised in that the measurement is effected in the solid angle range below which the substrate faces the source of the released metal via its region to be coated.

13. Process according to one of claims 1 to 12, characterised in that the vacuum chamber is evacuated to the UHV (ultra-high vacuum) residual gas pressure range.

14. Process according to one of claims 1 to 13, characterised in that the vacuum chamber is evacuated to at least $10^{-6}$ mbar, preferably to at least $10^{-9}$ mbar, as the initial pressure for the process.

15. Process according to one of claims 7 to 14, characterised in that a rate sensor used to measure the released metal rate is positioned in such a manner that it is essentially not affected by the simultaneous presence of oxygen in the vacuum chamber and that the substrates and the oxygen inlet are preferably separated from the remaining part of the vacuum chamber by means of a pressure stage and the metal source and the rate sensor are arranged in the said remaining part.

16. Process according to one of claims 1 to 15, characterised in that at least one of the following variables is controlled:

- temperature of the substrate,
- quantity of metal released per unit of time,
- quantity of oxygen admitted per unit of time or ratio of the quantity of metal released to the quantity of oxygen admitted per unit of time.

17. Process according to one of claims 1 to 16, characterised in that two of the three variables, i.e. substrate temperature, quantity of oxygen admitted per unit of time, rate of the quantity of metal released, are kept constant at least during predetermined coating intervals, preferably the substrate temperature and either the quantity of oxygen admitted per unit of time or the quantity of metal per unit of time, and that the third variable is controlled.

**18.** Process according to one of claims 1 to 17, characterised in that the layer is applied to one or two sides of a metal surface and, to this end, departing from the metal coating, a degree of oxidation increasing, preferably constantly, from the metal substrate is set, or a degree of oxidation decreasing, preferably constantly, towards a metal coating still to be effected.

**19.** Process according to one of claims 1 to 18, characterised in that the distribution of the degree of oxidation along the layer thickness is controlled by the time-dependent control of at least one of the three variables, i.e. temperature of the substrate, rate of the quantity of metal released, quantity of oxygen admitted per unit of time, the substrate temperature preferably being kept constant and the quantity of oxygen admitted per unit of time and the rate of the released metal being controlled, the quantity of oxygen admitted preferably in control steps at relatively large intervals and the rate of the released metal, on the other hand, with a smaller control time pattern.

**20.** Process according to one of claims 1 to 19, characterised in that the substrate temperature is maintained at a maximum of 600°C.

**21.** Process according to one of claims 1 to 20, characterised in that, departing from the substrate, the metal oxide layer is formed with the desired degree of oxidation profile, in that a constant rate of the released metal is set and the quantity of oxygen supplied is increased constantly in such a manner that the degree of reaction varies in a predetermined manner from one deposited monomolecular layer to the next in accordance with the metal release rate.

**22.** Process according to one of claims 1 to 21, characterised in that a space into which oxygen is admitted is separated from the remainder of the processing space together with the substrate by means of a pressure stage.

**23.** Process according to one of claims 1 to 22, characterised in that the activated oxygen is supplied in the form of ozone and/or oxygen monomers and/or electronically excited oxygen and/or ions.

**24.** Process according to one of claims 1 to 23, characterised in that the kinetic energy of the oxygen or of the activated oxygen is no higher than 10eV.

**25.** Process according to one of claims 1 to 24, characterised in that the oxygen is activated by a glow discharge, a microwave discharge, inductively coupled plasma and/or light radiation, in particular UV radiation.

**26.** Process according to one of claims 1 to 25, characterised in that an oxygen supply is connected to the vacuum chamber via a first valve on the supply side and via a second valve on the chamber side, a pump is connected between the first and the second valves via a third valve and the piping system is evacuated to at least $10^{-2}$mbar, preferably to at least $10^{-7}$ mbar, preferably with the piping system between the three valves being heated, preferably to at least 200°C, when the first and second valves are closed and the third valve is open, after which the third valve is closed, the first valve is opened and flooded with oxygen and this cycle is preferably carried out at least five times, the piping system is evacuated by the pump after the last flooding, again by closing the first valve and opening the third valve, and only then is the second valve opened.

**27.** Process according to one of claims 1 to 26, characterised in that Ir is released, preferably electron-beam evaporated, as the metal.

**28.** Process according to one of claims 1 to 27, characterised in that the quantity of metal released is adjusted with control times of $\leq 100$ ms, preferably $\leq$ 10 ms, preferably $\leq$ 1 ms.

**29.** Vacuum treatment installation for carrying out the process according to one of claims 1 to 28, comprising a vacuum chamber (1) designed at least for HV application with a pump unit (17), a gas-inlet arrangement (7) connected to an oxygen supply (11) with a flow-control arrangement (9), a heatable work-carrier arrangement (3) with a temperature-control arrangement (5) and at least one metal particle source (13) with a control-element arrangement ($E_{13}$) for the quantity of metal particles released by the source per unit of time, characterised in that a rate sensor for measuring the quantity of metal particles released per unit of time is provided with detection sensitivity of at least 0.01 nms$^{-1}$ (0.1 Åsec$^{-1}$) and a response time of no more than 100 msec and that the sensor (33) is connected in a control circuit as an actual-value sensor and the metal particle source is connected therein as a control element, the control circuit ensuring an averaged release rate over time and over the release area of the source deviating no more than 10 % from a desired value.

**30.** Installation according to claim 29, characterised in that the vacuum chamber (1) is designed for UHV application.

**31.** Installation according to one of claims 29 or 30, characterised in that the metal particle source is an evaporation source, preferably an electron-beam evaporation source.

**32.** Installation according to one of claims 29 to 31, characterised in that the metal particle source is designed for the delivery of metal particles at an averaged rate over time and over the release area thereof of up to at least 0.3 nms$^{-1}$, preferably at least 0.1 nms$^{-1}$, preferably at least 0.01 nms$^{-1}$, or even at least 0.005 nms$^{-1}$.

**33.** Installation according to one of claims 29 to 32, characterised in that the drift of the averaged metal particles released at the source over time and over the release area in relation to the desired value is $\leq 5$ % in 20 min, preferably $\leq 0.5$ % in 1 h.

**34.** Installation according to one of claims 29 to 33, characterised in that the rate sensor is arranged in the vacuum chamber in a solid angle range below which at least a substantial part of the work carrier faces the release area of the metal particle source.

**35.** Installation according to one of claims 29 to 34, characterised in that the detection sensitivity is no more than 0.001 nms$^{-1}$ (0.01 Ås$^{-1}$).

**36.** Installation according to one of claims 29 to 35, characterised in that the response time is no more than 10 ms, preferably no more than 1 ms.

**37.** Installation according to one of claims 29 to 36, characterised in that the work-carrier arrangement and the gas-inlet arrangement are arranged within a pressure stage chamber which is connected to the further inner space of the vacuum chamber (1) via at least one orifice and that the sensor for measuring the rate in the vacuum chamber is preferably arranged outside the pressure stage chamber.

**38.** Installation according to one of claims 29 to 37, characterised in that a quadrupole mass spectrometer, such as a QMA400 as sold by the Applicant, is provided in the chamber in order to measure the rate of the metal particles released from the particle source.

**39.** Installation according to one of claims 29 to 38, characterised in that the flow-control arrangement and/or the temperature-control arrangement and/or the rate-control element form the control arrangement of a respective control circuit.

**40.** Installation according to one of claims 29 to 39, characterised in that the flow-control arrangement is connected to a control unit (31), as a result of which the flow rate of oxygen can be controlled as a function of time.

**41.** Installation according to one of claims 29 to 40, characterised in that the gas-inlet arrangement is connected via a first valve and a second valve to the oxygen supply and a pump is connected between these valves via a third valve.

**42.** Installation according to one of claims 29 to 41, characterised in that the metal particle source can be controlled with control times of $\leq 100$ ms, preferably $\leq 10$ ms, preferably even $\leq 1$ ms in relation to the release rate.

**43.** Component coated with at least one metal oxide layer, characterised in that, given a pattern surface area of at least 15 mm$^2$, at least 30 % of the pattern surface area is free of microcracks and is selectively permeable at most for predetermined ions and the degree of oxidation in the layer increases constantly from the substrate over a predetermined thickness range as viewed in the direction of the expansion of the thickness of the layer.

**44.** Component according to claim 43, characterised in that at least 90 % of the surface area is selectively permeable at most for predetermined ions.

**Revendications**

**1.** Procédé pour la fabrication d'une couche d'oxyde métallique sur un substrat, selon lequel on fait le vide dans une chambre à vide au moins jusqu'à la plage de pression de vide poussé, et du métal est libéré dans la chambre à vide, dans laquelle de l'oxygène est introduit, et selon lequel la température du substrat est maintenue au-dessous de 900°C,

caractérisé en ce que pour la fabrication de couches sélectivement conductrices au maximum pour des ions d'un type prédéfini, l'énergie cinétique de particules métalliques libérées arrivant sur le substrat est au maximum de 10 eV et le degré d'oxydation de la couche est augmenté, à partir du substrat, selon une grille de commande dans le temps, au maximum en fonction du temps de dépôt d'une couche monoatomique ou monomoléculaire.

**2.** Procédé selon la revendication 1, caractérisé en ce que le métal est libéré dans la chambre de telle sorte que la vitesse de libération moyenne dans le temps et sur la surface de libération, à partir d'une source de particules métalliques, ne dépasse pas 0,3 nms$^{-1}$, de préférence 0,1 nms$^{-1}$ et plus spécialement 0,01 nms$^{-1}$, voire 0,005 nms$^{-1}$.

**3.** Procédé selon la revendication 1 ou 2, caractérisé en ce que la précision de la vitesse de libération moyenne du métal, dans le temps et sur une surface de libération, à partir d'une source métallique, est ≤ 10 %, de préférence ≤ 1 %, par rapport à une valeur théorique.

4. Procédé selon l'une des revendications 1 à 3, caractérisé en ce que la dérive de la vitesse de libération moyenne du métal, dans le temps et sur la surface de libération, à partir d'une source métallique, est ≤ 5 % en 20 minutes, de préférence ≤ 0,5 % en 1 heure.

5. Procédé selon l'une des revendications 1 à 4, caractérisé en ce qu'on amène sur le substrat ou la couche qui se forme sur celui-ci l'oxygène et les particules métalliques essentiellement à l'état non réagi, et la couche d'oxyde métallique se forme in situ.

6. Procédé selon l'une des revendications 1 à 5, caractérisé en ce que le métal est évaporé, de préférence à l'aide d'un faisceau d'électrons.

7. Procédé selon l'une des revendications 1 à 6, caractérisé en ce qu'on mesure la vitesse du métal libéré à partir d'une source métallique.

8. Procédé selon la revendication 7, caractérisé en ce que la mesure a lieu à l'aide d'un spectromètre de masse quadripolaire, par exemple à l'aide d'un spectromètre de masse QMA400 vendu par le déposant.

9. Procédé selon la revendication 7 ou 8, caractérisé en ce que la mesure de la vitesse du métal libéré est utilisée comme mesure de valeur réelle dans un circuit de régulation pour la vitesse du métal libéré, et la vitesse mentionnée et, ainsi, le degré d'oxydation sur la couche qui se forme sont au moins réglés avec la grandeur de référence du circuit de régulation.

10. Procédé selon l'une des revendications 7 à 9, caractérisé en ce qu'on utilise, pour mesurer la vitesse, un détecteur de vitesse à sélection de matériau qui présente une sensibilité de détection ≤ 0,01 nms$^{-1}$ (0,1 Ås$^{-1}$), de préférence ≤ 0,001 nms$^{-1}$ (0,01 Ås$^{-1}$) par rapport à la libération des particules métalliques au niveau de la source métallique.

11. Procédé selon l'une des revendications 7 à 10, caractérisé en ce qu'on utilise, pour mesurer la vitesse, un détecteur de vitesse qui présente un temps de réaction ≤ 100 ms, de préférence ≤ 10 ms et plus spécialement ≤ 1 ms.

12. Procédé selon la revendication 7, caractérisé en ce que la mesure a lieu dans la zone d'angle solide dans laquelle le substrat, avec sa zone à revêtir, est à portée optique de la source du métal libéré.

13. Procédé selon l'une des revendications 1 à 12, caractérisé en ce qu'on fait le vide dans la chambre à vide jusqu'à la plage de pression de gaz résiduel d'ultravide.

14. Procédé selon l'une des revendications 1 à 13, caractérisé en ce que, comme pression initiale de procédé, on fait le vide dans la chambre à vide jusqu'à au moins 10$^{-6}$ mbar, de préférence au moins 10$^{-9}$ mbar.

15. Procédé selon l'une des revendications 7 à 14, caractérisé en ce qu'un détecteur de vitesse utilisé pour la mesure de la vitesse de métal libéré est positionné de telle sorte qu'il ne soit pratiquement pas influencé par la présence simultanée d'oxygène dans la chambre à vide, et en ce que les substrats et l'orifice d'admission d'oxygène sont de préférence séparés de la partie restante de la chambre à vide par l'intermédiaire d'un palier de pression, et la source métallique est disposée avec le détecteur de vitesse dans ladite partie restante.

16. Procédé selon l'une des revendications 1 à 15, caractérisé en ce qu'on règle l'une au moins des grandeurs suivantes :

- température du substrat,
- quantité de métal libéré par unité de temps,
- quantité d'oxygène introduit par unité de temps ou rapport de la quantité de métal libéré à la quantité d'oxygène introduit, par unité de temps.

17. Procédé selon l'une des revendications 1 à 16, caractérisé en ce que deux des trois grandeurs définies par la température du substrat, la quantité d'oxygène introduit par unité de temps et la vitesse de la quantité de métal libéré sont maintenues constantes au moins pendant des périodes d'application de revêtement prédéfinies, de préférence la température du substrat et soit la quantité d'oxygène introduit par unité de temps, soit la quantité de métal par unité de temps, et en ce que la troisième grandeur est commandée.

18. Procédé selon l'une des revendications 1 à 17, caractérisé en ce que la couche est fabriquée unilatéralement ou bilatéralement contre une surface métallique et à cet effet, à partir de l'application d'un revêtement métallique, on règle un degré d'oxydation qui augmente, de préférence de manière continue, à partir du substrat métallique, ou un degré d'oxydation qui va en diminuant, de préférence de manière continue, en direction d'un revêtement métallique qui doit encore être appliqué.

19. Procédé selon l'une des revendications 1 à 18, caractérisé en ce que le long de l'épaisseur de couche, on commande la répartition de degré d'oxydation grâce à un contrôle dans le temps de l'une au moins des trois grandeurs (température du substrat, vitesse de la quantité de métal libéré et quantité d'oxygène introduit par unité de temps), on maintient de préférence la température du substrat constante et on contrôle la quantité d'oxygène introduit par unité de temps ainsi que la vitesse du métal libéré, la quantité d'oxygène introduit étant contrôlée par phases de réglage présentant des intervalles de temps assez longs, tandis que la vitesse du métal libéré est contrôlée avec une trame de temps de réglage plus petite.

20. Procédé selon l'une des revendications 1 à 19, caractérisé en ce que la température du substrat est maintenue à 600°C maximum.

21. Procédé selon l'une des revendications 1 à 20, caractérisé en ce que, à partir du substrat, on forme la couche d'oxyde métallique avec un profil de degré d'oxydation souhaité, en réglant une vitesse constante pour le métal libéré et en augmentant continuellement la quantité d'oxygène amené, de telle sorte que le degré de réaction varie d'une manière prédéfinie d'une couche monomoléculaire déposée à l'autre, en fonction de la vitesse de libération de métal.

22. Procédé selon l'une des revendications 1 à 21, caractérisé en ce qu'un espace dans lequel l'oxygène est introduit et qui contient le substrat est séparé du reste de l'espace de traitement par un palier de pression.

23. Procédé selon l'une des revendications 1 à 22, caractérisé en ce que l'oxygène excité est amené sous forme d'ozone et/ou de monomères d'oxygène et/ou d'oxygène excité par voie électronique et/ou d'ions.

24. Procédé selon l'une des revendications 1 à 23, caractérisé en ce que l'énergie cinétique de l'oxygène ou de l'oxygène activé n'est pas supérieure à 10 eV.

25. Procédé selon l'une des revendications 1 à 24, caractérisé en ce que l'oxygène est activé par une décharge lumineuse, une décharge de micro-ondes, un plasma à couplage inductif et/ou un rayonnement lumineux, en particulier ultraviolet.

26. Procédé selon l'une des revendications 1 à 25, caractérisé en ce qu'on relie une réserve d'oxygène à la chambre à vide grâce à une première soupape, côté réserve, et à une deuxième soupape, côté chambre ; on raccorde une pompe entre les première et deuxième soupape grâce à une troisième soupape et on fait le vide dans le système de conduites jusqu'à au moins $10^{-2}$ mbar, de préférence au moins $10^{-7}$ mbar, en chauffant de préférence le système de conduites entre les trois soupapes, de préférence à au moins 200°C, alors que les première et deuxième soupapes sont fermées et la troisième soupape ouverte ; puis on ferme la troisième soupape, on ouvre la première et on remplit d'oxygène ; et on effectue ce cycle de préférence au moins cinq fois ; après le dernier remplissage, on fait à nouveau le vide dans le système de conduites à l'aide de la pompe, en fermant la première soupape et en ouvrant la troisième ; et à ce moment seulement, on ouvre la deuxième soupape.

27. Procédé selon l'une des revendications 1 à 26, caractérisé en ce que le métal libéré est Ir, et il est de préférence évaporé par faisceau d'électrons.

28. Procédé selon l'une des revendications 1 à 27, caractérisé en ce que la quantité de métal libéré est ajustée avec des temps de réglage ≤ 100 ms, de préférence ≤ 10 ms et plus spécialement ≤ 1 ms.

29. Installation de traitement sous vide pour la mise en oeuvre du procédé selon l'une des revendications 1 à 28, comprenant une chambre à vide (1) qui est construite au moins pour une application à vide poussé et qui comporte un groupe moto-pompe (17) d'un dispositif d'admission de gaz (7) relié à une réserve d'oxygène (11) et pourvu d'un dispositif de réglage de débit (9), un dispositif porte-pièce (3) qui est apte à être chauffé et qui comporte un dispositif de réglage de température (5), et au moins une source de particules métalliques (13) qui comporte un dispositif formant composant de réglage ($E_{13}$) pour la quantité de particules métalliques libérée par unité de temps par la source,
   caractérisée en ce qu'il est prévu un détecteur de vitesse pour mesurer la quantité de particules métalliques libérées par unité de temps, qui présente une sensibilité de détection d'au moins 0,01 nms$^{-1}$ (0,1 Ås$^{-1}$) et un temps de réaction de 100 ms maximum, et en ce que le détecteur (33) est monté dans un circuit de régulation comme capteur de valeurs réelles, et la source de particules métalliques comme composant de réglage, le circuit de régulation garantissant une vitesse de libération moyenne dans le temps et sur la surface de libération de la source qui diffère de 10 % maximum d'une valeur théorique prédéfinie.

30. Installation selon la revendication 29, caractérisée en ce que la chambre à vide (1) est conçue pour des applications à ultravide.

31. Installation selon la revendication 29 ou 30, caractérisée en ce que la source de particules métalliques est une source d'évaporation, de préférence une source d'évaporation par faisceau d'électrons.

**32.** Installation selon l'une des revendications 29 à 31, caractérisée en ce que la source de particules métalliques est conçue pour émettre des particules métalliques à une vitesse moyenne dans le temps et sur sa surface de libération qui va jusqu'à au moins 0,3 nms$^{-1}$, de préférence au moins 0,1 nms$^{-1}$ et plus spécialement au moins 0,01 nms$^{-1}$, voire au moins 0,005 nms$^{-1}$.

**33.** Installation selon l'une des revendications 29 à 32, caractérisée en ce que la dérive dans le temps de la quantité moyenne, dans le temps et sur la surface de libération, de particules métalliques libérées au niveau de la source est ≤ 5 % en 20 minutes, de préférence ≤ 0,5 % en 1 heure, par rapport à la valeur théorique.

**34.** Installation selon l'une des revendications 29 à 33, caractérisée en ce que le détecteur de vitesse est disposé dans la chambre à vide dans une zone d'angle solide dans laquelle le substrat, avec au moins une partie essentielle du porte-pièce est à portée optique de la surface de libération de la source de particules métalliques.

**35.** Installation selon l'une des revendications 29 à 34, caractérisée en ce que la sensibilité de détection est de 0,001 nms$^{-1}$ (0,01 Ås$^{-1}$) maximum.

**36.** Installation selon l'une des revendications 29 à 35, caractérisée en ce que le temps de réaction est de 10 ms maximum, de préférence de 1 ms maximum.

**37.** Installation selon l'une des revendications 29 à 36, caractérisée en ce que le dispositif porte-pièce et le dispositif d'admission de gaz sont disposés à l'intérieur d'une chambre à paliers de pression qui est reliée grâce à au moins un diaphragme à la suite de l'espace intérieur de la chambre à vide (1), et en ce que le détecteur prévu pour mesurer la vitesse est disposé de préférence dans la chambre à vide à l'extérieur de la chambre à paliers de pression.

**38.** Installation selon l'une des revendications 29 à 37, caractérisée en ce qu'il est prévu, dans la chambre, un spectromètre de masse quadripolaire tel qu'un QMA400 vendu par le déposant pour mesurer la vitesse de particules métalliques libérées par la source de particules.

**39.** Installation selon l'une des revendications 29 à 38, caractérisée en ce que le dispositif de réglage de débit et/ou le dispositif de réglage de température et/ou le composant de réglage de vitesse forment le dispositif de réglage d'un circuit de régulation correspondant.

**40.** Installation selon l'une des revendications 29 à 39, caractérisée en ce que le dispositif de réglage de débit est relié à une unité de commande (31), moyennant quoi, en fonction du temps, le débit d'oxygène est commandé ou régulé suivant une courbe dans le temps apte à être prédéfinie.

**41.** Installation selon l'une des revendications 29 à 40, caractérisée en ce que le dispositif d'admission de gaz est relié à la réserve d'oxygène par une première et une deuxième soupape, et une pompe est raccordée entre ces soupapes grâce à une troisième soupape.

**42.** Installation selon l'une des revendications 29 à 41, caractérisée en ce que la source de particules métalliques est apte à être réglée, pour la vitesse de libération, à des temps de réglage ≤ 100 ms, de préférence ≤ 10 ms et plus spécialement ≤ 1 ms.

**43.** Pièce revêtue d'au moins une couche d'oxyde métallique, caractérisée en ce que pour un quadrillage de surface d'au moins 15mm$^2$ de surface quadrillée, au moins 30% de ladite surface sont exempts de microfissures et sont perméables sélectivement au maximum pour des ions prédéfinis, et le degré d'oxydation dans la couche, si on considère le sens d'extension en épaisseur de la couche, va en augmentant de manière continue à partir du substrat, sur une plage d'épaisseur prédéfinie.

**44.** Pièce selon la revendication 43, caractérisée en ce qu'au moins 90 % de la surface sont perméables sélectivement au maximum pour des ions prédéfinis.

FIG.1

FIG. 2

FIG. 3

$W_{O_2}$
$(X)$

$T_1$

t

$W_r$

$T_1$

t

V

$T_1$

t

FIG.4

Fig. 5

Fig. 6

Fig. 7

FIG. 8

FIG. 9

23

FIG.10